# EUROPEAN PATENT APPLICATION

(11) **EP 2 733 509 A1**
(43) Date of publication of application: **21.05.2014**
(21) Application number: 12306435.4
(22) Date of filing: 19.11.2012
(51) Int. Cl.: G01V 13/00

(54) **Wellbore instrument clock oscillator and instrument system made therewith**

(71) Applicant: Services Pétroliers Schlumberger, 75007 Paris (FR); SCHLUMBERGER TECHNOLOGY B.V., 2514 JG The Hague (NL); Schlumberger Holdings Limited, Tortola 1110 (VG); PRAD Research and Development Limited, Road Town, Tortola 1110 (VG)
(72) Inventor: Liu, Junchen, 92130 Issy les Moulineaux (FR); Barakat, Simon, 91380 Chilly-Mazarin (FR)
(74) Representative: Rzaniak, Martin

(57) **Abstract**

A clock oscillator (10) includes a first crystal controlled oscillator (12), a second crystal controlled oscillator (34) and a logic controller (18) functionally coupled to the first and second crystal controlled oscillators. The logic controller is programmed to calculate a frequency of the first crystal controlled oscillator as a function of the frequency of the first crystal controlled oscillator with respect to a frequency of the second crystal controlled oscillator characterized with respect to an environmental parameter.

## Description

### Background

This disclosure relates generally to the field of instruments used in wellbores to make measurements of physical properties of formations adjacent to the wellbore. More specifically, the disclosure relates to clock oscillators that are used with such instruments for timing of operating events in the instruments.

Wellbore instruments for making measurements of properties of subsurface formations include sensors that make measurements of one or more physical parameters of the formations. The sensors may be disposed in housings that can be conveyed along the interior of the wellbore, for example, by electrical cable or using a drill string. Such instruments may include internal processors for making calculations from the sensors measurements, digitally sampling the measurements, formatting the measurements for inclusion in various forms of telemetry to communicate the measurements to the surface, and data storage devices for retaining measurements in the instrument housing for later retrieval. All of the foregoing require precise clock oscillators whose frequency is well known and stable with respect to temperature or can be accurately characterized with respect to temperature. This is particularly the case with measurements made by sensors disposed in a drill string. Measurements made by such sensors may be stored in an internal memory in the instrument with along with an indication of the time at which the measurement was made. A record may be made at the surface of the axial position of the sensor(s) with respect to time, and when the instrument is retrieved from the wellbore, the time/measurement data stored in the instrument memory may be correlated to the time/depth record made at the surface to enable generation of a measurement/depth record.

Irrespective of the type of instrument used and the type of measurement made, there exists a need for very precise clock oscillators to enable precisely timed control over operation of the various instrument functions.

### Summary

A clock oscillator according to one aspect includes a first crystal controlled oscillator, a second crystal controlled oscillator and a logic controller functionally coupled to the first and second crystal controlled oscillators. The logic controller is programmed to calculate a frequency of the first crystal controlled oscillator as a function of the frequency of the first crystal controlled oscillator with respect to a frequency of the second crystal controlled oscillator characterized with respect to an environmental parameter.

Other aspects and advantages will be apparent from the description and claims which follow.

### Brief Description of the Drawings

FIG. 1 shows an example wellsite system that may use an example clock oscillator according to the present disclosure;

FIG. 2 shows a wireline well logging instrument and acquisition system that may use an example clock oscillator according to the present disclosure; and

FIG. 3 shows an example clock oscillator system.

### Detailed Description

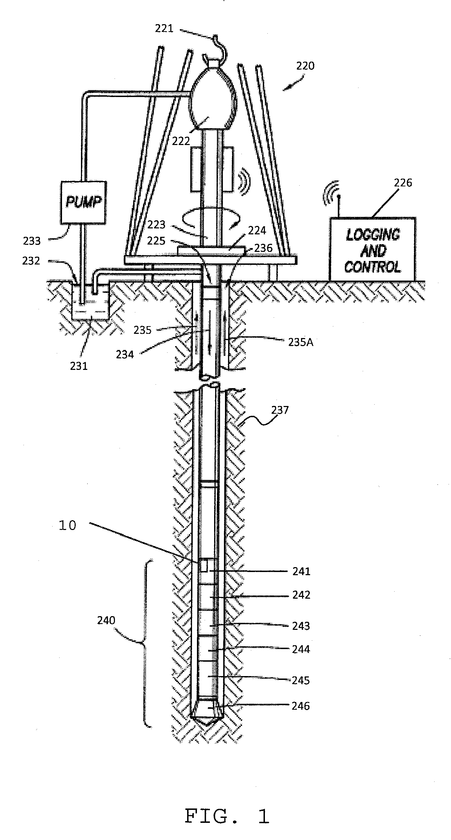

FIG. 1 illustrates a wellsite system in which data to be used according to examples of the present disclosure may be used. The wellsite can be onshore or offshore. In this example system, a borehole is formed in subsurface formations by rotary drilling in a manner that is well known. A drill string 225 is suspended within a borehole 236 and has a bottom hole assembly (BHA) 240 which includes a drill bit 246 at its lower end. A surface system 220 includes platform and derrick assembly positioned over the borehole 236, the assembly including a rotary table 224, kelly (not shown), hook 221, and rotary swivel 222. The drill string 225 is rotated by the rotary table 224 energized by means not shown, which engages the kelly (not shown) at the upper end of the drill string 225. The drill string 225 is suspended from the hook 221, attached to a traveling block (also not shown), through the kelly (not shown) and the rotary swivel 222 which permits rotation of the drill string 225 relative to the hook 221. As is well known, a top drive system could be used instead of the rotary table system shown in FIG. 1.

In the illustrated example, the surface system further includes drilling fluid or mud 232 stored in a pit 231 formed at the well site. A pump 233 delivers the drilling fluid to the interior of the drill string 225 via a port (not shown) in the swivel 222, causing the drilling fluid to flow downwardly through the drill string 225 as indicated by the directional arrow 234. The drilling fluid exits the drill string via ports (not shown) in the drill bit 246, and then circulates upwardly through an annulus region 235 between the outside of the drill string 225 and the wall of the borehole 236, as indicated by the directional arrows 235 and 235A. In this well known manner, the drilling fluid lubricates the drill bit 246 and carries formation cuttings up to the surface as it is returned to the pit 231 for recirculation.

The BHA 240 of the illustrated embodiment may include a measuring-while-drilling (MWD) tool 241, a logging-while-drilling (LWD) tool 244, a rotary steerable directional drilling system 245 and motor, and the drill bit 250. It will also be understood that more than one LWD tool and/or MWD tool can be employed, e.g. as represented at 243.

The LWD tool 244 is housed in a special type of drill collar, as is known in the art, and can contain one or a plurality of known types of logging tools. The LWD tool 244 may include capabilities for measuring, processing, and storing information, as well as for communicating with the surface equipment. In the present example, the LWD tool 244 may any one or more well logging instruments known in the art, including, without limitation, electrical resistivity, acoustic velocity or slowness, neutron porosity, gamma-gamma density, neutron activation spectroscopy, nuclear magnetic resonance and natural gamma emission spectroscopy.

The MWD tool 241 is also housed in a special type of drill collar, as is known in the art, and can contain one or more devices for measuring characteristics of the drill string and drill bit. The MWD tool 241 further includes an apparatus 242 for generating electrical power to the downhole system. This may typically include a mud turbine generator powered by the flow of the drilling fluid, it being understood that other power and/or battery systems may be employed. In the present embodiment, the MWD tool 241 may include one or more of the following types of measuring devices: a weight-on-bit measuring device, a torque measuring device, a vibration measuring device, a shock measuring device, a stick slip measuring device, a direction measuring device, and an inclination measuring device. The power generating apparatus 242 may also include a drilling fluid flow modulator for communicating measurement and/or tool condition signals to the surface for detection and interpretation by a logging and control unit 226.

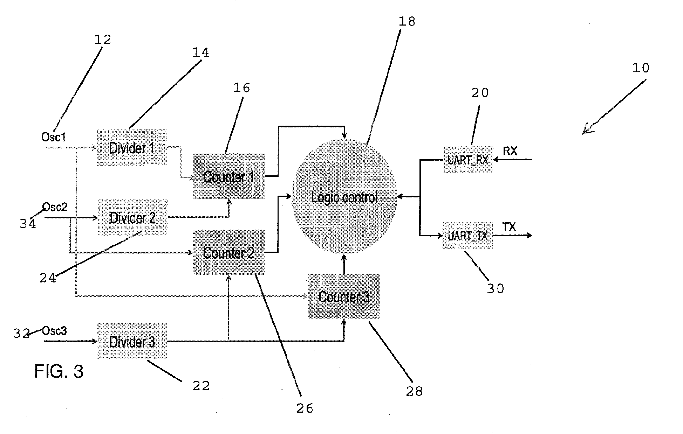

The instruments shown in FIG. 1 may include a data storage device coupled to a clock (as will be explained with reference to FIG. 3), shown generally at 100. The data storage device may record signals from the various devices explained above and have included with such recordings a time at which the particular recorded measurement was made. A record may be made in the surface logging and control unit 226 of the depth of each instrument at any moment in time. A record of measurements with reference to depth may be made by correlating the content of the data storage device 100 with the time/depth record made in the logging and control unit 226. For such purposes a precise clock is needed in the wellbore deployed instruments; an example of such clock will be explained with reference to FIG. 3.

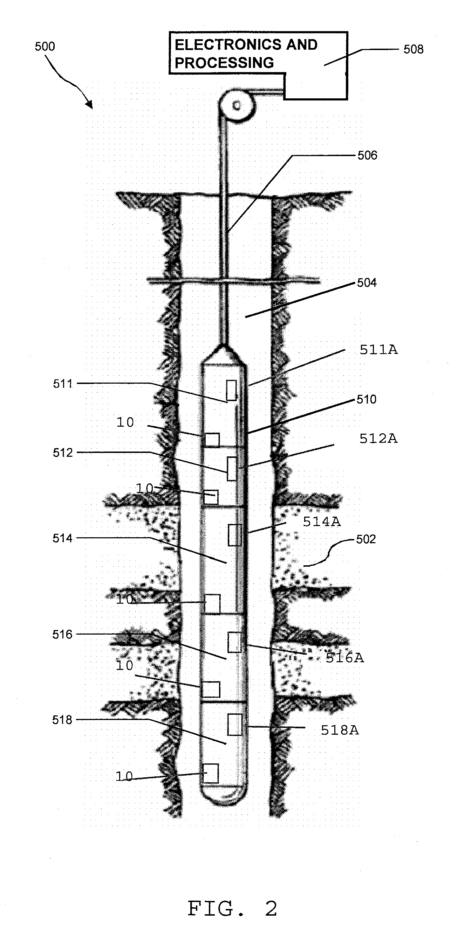

Referring to FIG. 2, an example wireline tool 510 is shown that may be another environment in which aspects of the present disclosure may be implemented. The example wireline tool 510 is suspended in a wellbore 504 from the lower end of an armored multiconductor cable 506 that is spooled on a winch (not shown) at the Earth's surface. At the surface, the cable 506 is communicatively coupled to an electronics and processing system 508. The example wireline tool 510 may includes an elongated body that may include a scintillation type radiation detector 510A with a multichannel analyzer. Additional components may also be included in the wireline tool 510. The wireline tool may include various sensing devices shown at 511A, 512A, 514A, 516A and 518A that may be one or more of the various example devices as explained with reference to FIG. 1. Tool 511A may include a telemetry system to enable transmission of signals from the example devices 512A, 514A, 516A, 518a to the surface in a decodable form by equipment in the surface electronics 508. Timing of operation of the various devices explained above may be regulated by a clock 10 as will be explained with reference to FIG. 3.

Though FIGS. 1 and 2 illustrate example while-drilling and wireline systems of conveyance, respectively, other systems of conveyance can be used. Examples of other systems of conveyance that can be used with certain aspects described in the foregoing disclosure include coiled tubing, drillpipe, and slickline systems.

As explained in the Background section herein, any one or more of the instruments shown in and explained with reference to FIGS. 1 and 2 may use one or more clock oscillators to, for example, control timing of various instrument operating functions and to make a time/measurement record of the measurements made by the various sensors in the instruments.

An example clock is shown in FIG. 3. The clock 10 may include a first crystal controlled oscillator 12 (Osc1) an a second crystal controlled oscillator 34 (Osc2). Output of the first crystal controlled oscillator 12 may be conducted through a first divider 14, and then to a first counter 16, or the first crystal controlled oscillator 12 may be coupled directly to the first counter 16. Output of the second crystal controlled oscillator 34 may be coupled through a second divider 24 to the first counter 16, and such output also may be directly connected to a second counter 26.

Output of the first crystal controlled oscillator may also be conducted to a third counter 28. During calibration of the clock 10, an external, high precision and accuracy clock signal 32 (Osc3) may be coupled (e.g., through a third divider 22) to the third counter 28. The clock signal 32 may be, for example, a global positioning satellite system (GPS) clock signal used to calibrate and characterize the output of the first crystal controlled oscillator 12 and the second crystal controlled oscillator 34 with respect to an environmental parameter, e.g., pressure and/or temperature.

Operation of the clock and its calibration may be described as follows. One oscillator (first crystal controlled oscillator 12) which is temperature dependent is calibrated with temperature variation against the second crystal oscillator 34 which is also temperature dependent. Calibration coefficients may be saved in a microprocessor, e.g., logic controller 18. When the clock 10 is used in a wellbore instrument and is subject to temperature changes one oscillator frequency is measured with a gate time defined by the other oscillator frequency and is compares to the calibration data to determine the exact frequency of the first crystal oscillator. Then this clock is input to a microprocessor, e.g., logic controller 18 in order realize the function of the clock 10. The clock 10 signal may be communicated, for example, using transmitter 30 and receiver 20 elements, to the various components in the wellbore instruments (see FIGS. 1 and 2).

The determination of the clock output may be explained as follows. Output of the three counters 16, 26, 28 may be conducted to the logic controller 18. The logic controller may include several functions:
(i) memory to record a relationship between the frequency f₁₍₂₎ (Osc1 as a function of Osc2) and f₁ (Osc1) obtained during calibration of the clock using Osc3;
(ii) capability to calculate a correct f₁ (Osc1) value based on f₁₍₂₎ (Osc1 in function of Osc2) measured during operation of the clock 10 in an actual wellbore instrument; and
(iii) capability to realize a "real time clock" function based on the real value of f₁ (Osc1).
The foregoing may be implemented as follows, wherein *f₁* is the frequency of Osc1, *f₂* is the frequency of Osc2 *f₂₍₀₎* is a value of the second divider 24 which is the value of Osc2 set in order to create a gate time ≈ 1 second to measure *f₁*.
counter 1 measures the function f₁₍₂₎=f₂₍₀₎*f₁/f₂
counter 2 measures f₂;

counter 3 measures f₁;

During calibration, f₁₍₂₎ is measured with respect to f₁ over a selected range of the environmental parameter (e.g., pressure and/or temperature). In use in a wellbore instrument, wherein Osc3 is not used f₁₍₂₎ is measured and converted to the real frequency of f₁ in the logic controller 18 based on the above determined calibration data.

A clock made as explained with reference to FIG. 3 may, based on simulation, have precision in a range of 0.64 parts per million.

While the invention has been described with respect to a limited number of embodiments, those skilled in the art, having benefit of this disclosure, will appreciate that other embodiments can be devised which do not depart from the scope of the invention as disclosed herein. Accordingly, the scope of the invention should be limited only by the attached claims.

## Claims

1. A clock oscillator, comprising:
a first crystal controlled oscillator;
a second crystal controlled oscillator; and
a logic controller functionally coupled to the first and second crystal controlled oscillators and programmed to calculate a frequency of the first crystal controlled oscillator as a function of the frequency of the first crystal controlled oscillator with respect to a frequency of the second crystal controlled oscillator characterized with respect to an environmental parameter.

2. The clock oscillator of claim 1 further comprising an input to the logic controller for a reference oscillator signal wherein the logic controller is further programmer to determine the frequency of the first crystal controlled oscillator with respect to the second crystal controlled oscillator with respect to the environmental parameter by comparing the reference oscillator signal to the frequency of the first crystal controlled oscillator with respect to the second crystal controlled oscillator with respect to the environmental parameter..

3. The clock oscillator of claim 1 further comprising a counter coupled between each crystal controlled oscillator and the logic controller.

4. The clock oscillator of claim 1 wherein the environmental parameter comprises at least one of pressure and temperature.

5. A well logging instrument comprising:
at least one sensor; and
a clock operatively coupled to the at least one sensor to control operation timing thereof, the clock comprising a first crystal controlled oscillator, a second crystal controlled oscillator and a logic controller functionally coupled to the first and second crystal controlled oscillators and programmed to calculate a frequency of the first crystal controlled oscillator as a function of the frequency of the first crystal controlled oscillator with respect to a frequency of the second crystal controlled oscillator characterized with respect to an environmental parameter.

6. The well logging instrument of claim 5 wherein the at least one sensor and the clock are disposed in a housing configured to traverse a wellbore drilled through subsurface formations.

7. The well logging instrument of claim 5 wherein the environmental parameter comprises at least one of pressure and temperature.

8. The well logging instrument of claim 1 further comprising a data storage device within the instrument, the data storage device functionally coupled to the clock, the data storage device configured to record signals from sensors in the instrument with a corresponding time signal generated by the clock.

9. A method for operating a wellbore instrument clock, comprising:
in a processor determining a frequency of a first oscillator with respect to a frequency of a second oscillator with respect to an environmental parameter; and
in a processor determining frequency of the first oscillator by determining a function of the first oscillator with respect to the second oscillator..

10. The method of claim 9 wherein the determining the frequency of the first and second oscillators with respect to the environmental parameter comprises operating the first and second oscillators at selected values of the environmental parameter and comparing the frequencies thereof to an external clock signal.

11. The method of claim 10 wherein the external clock signal comprises a global positioning system satellite clock signal.

12. The method of claim 9 further comprising disposing the clock in a wellbore instrument, disposing the instrument in a wellbore, making measurements with at least one sensor disposed in the wellbore instrument and recording times at which the measurements were made using an output of the clock as a time reference.

13. The method of claim 12 further comprising generating a record with respect to depth of the measurements made by the wellbore instrument by correlating the recorded measurements with a record made at the surface of a depth in the wellbore of the wellbore instrument with respect to time.

14. The method of claim 13 wherein the wellbore instrument is coupled to an end of an electrical cable.

15. The method of claim 9 further comprising controlling timing of operation of a sensor in a wellbore instrument using a timing signal generated by the clock.
